# EUROPEAN PATENT APPLICATION

(11) **EP 3 299 834 A1**
(43) Date of publication of application: **28.03.2018**
(21) Application number: 17192734.6
(22) Date of filing: 22.09.2017
(51) Int. Cl.: G01R 33/50, G01R 33/567

(54) **MAGNETIC RESONANCE IMAGING APPARATUS AND MAGNETIC RESONANCE IMAGING METHOD FOR CARDIAC-TRIGGERED T1 MAPPING**

(30) Priority: 23.09.2016 JP 2016186191
(71) Applicant: Toshiba Medical Systems Corporation, Otawara-shi, Tochigi-ken 324-8550 (JP)
(72) Inventor: SONG, Ruixiao, Tochigi, 324-8550 (JP); BANNAE, Shuhei, Tochigi, 324-8550 (JP); MACHII, Yutaka, Tochigi, 324-8550 (JP); NAGASHIMA, Masaaki, Tochigi, 324-8550 (JP)
(74) Representative: Moreland, David

(57) **Abstract**

A magnetic resonance imaging apparatus according to an embodiment includes processing circuitry (150) and sequence control circuitry (10). The processing circuitry (150) sets a pattern based on information on heartbeats or pulsebeats of a subject, the pattern being an imaging condition of a pulse sequence for collecting data at a plurality of timings along a relaxation curve of longitudinal magnetization in synchronization with heartbeats or pulsebeats and the pattern defining a relation between heartbeats or pulsebeats, an inversion pulse, and a data collection timing. The sequence control circuitry (10) controls execution of the pulse sequence according to the pattern.

## Description

### BACKGROUND

A T₁ map displaying T₁ of a tissue is considered to be effective for diagnosis of, for example, diffuse myocardial fibrosis. As a magnetic resonance imaging method for creating the T₁ map, for example, there is MOLLI (modified Look-Locker Inversion Recovery) method.

However, MOLLI method is susceptible to factors such as a heart rate. Therefore, if a heart rate changes, the accuracy of a measured T₁ value may decrease.

### BRIEF DESCRIPTION OF THE DRAWINGS

FIG. 1 is a diagram illustrating a magnetic resonance imaging apparatus according to a first embodiment;
FIG. 2 is an explanatory diagram of a background of the magnetic resonance imaging apparatus according to the first embodiment;
FIG. 3 is a flowchart for explaining a flow of processing performed by the magnetic resonance imaging apparatus according to the first embodiment;
FIG. 4 is an explanatory diagram of the processing performed by the magnetic resonance imaging apparatus according to the first embodiment;
FIG. 5 is an explanatory diagram of the processing performed by the magnetic resonance imaging apparatus according to the first embodiment;
FIG. 6 is a flowchart for explaining a flow of processing performed by a magnetic resonance imaging apparatus according to a second embodiment;
FIG. 7 is an explanatory diagram of an example of a user interface according to the magnetic resonance imaging apparatus according to the second embodiment;
FIG. 8 is an explanatory diagram of an example of the user interface according to the magnetic resonance imaging apparatus according to the second embodiment;
FIG. 9 is a flowchart for explaining a flow of processing performed by a magnetic resonance imaging apparatus according to a third embodiment;
FIG. 10 is a flowchart for explaining a flow of processing performed by a magnetic resonance imaging apparatus according to another embodiment; and
FIG. 11 is an explanatory diagram of a hardware configuration of an image processing apparatus according to the embodiments.

### DETAILED DESCRIPTION

A magnetic resonance imaging apparatus according to an embodiment includes processing circuitry and sequence control circuitry. The processing circuitry sets a pattern based on information on heartbeats or pulsebeats of a subject, the pattern being an imaging condition of a pulse sequence for collecting data at a plurality of timings along a relaxation curve of longitudinal magnetization in synchronization with heartbeats or pulsebeats and the pattern defining a relation between heartbeats or pulsebeats, an inversion pulse, and a data collection timing. The sequence control circuitry controls execution of the pulse sequence according to the pattern.

A magnetic resonance imaging apparatus according to embodiments will be explained below in detail with reference to the accompanying drawings.

### First embodiment

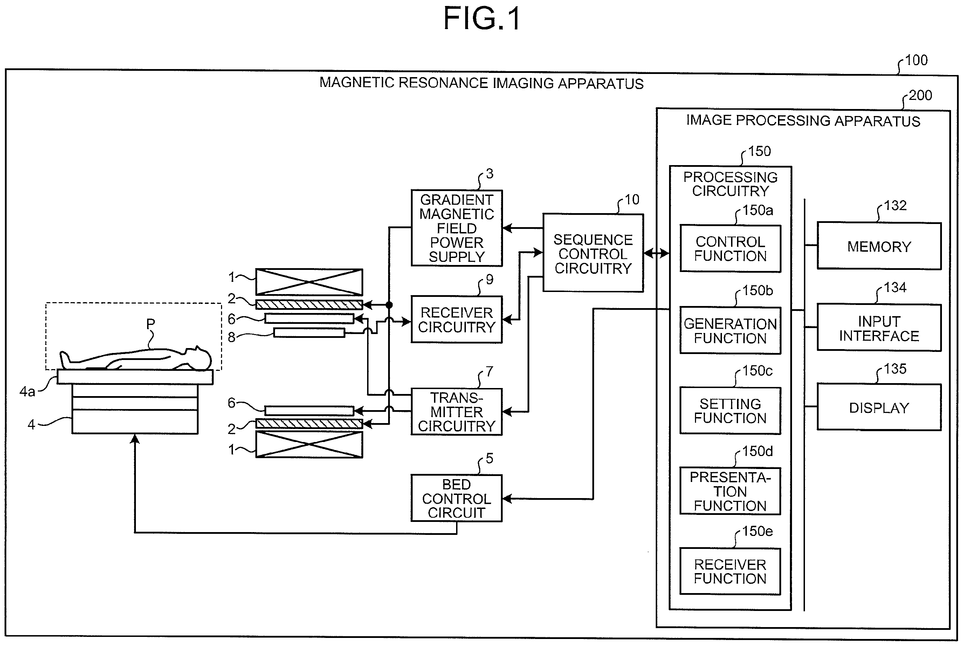

FIG. 1 is a diagram illustrating a magnetic resonance imaging apparatus 100 according to a first embodiment. A subject P (a figure surrounded by the dotted line in FIG. 1) is not included in the magnetic resonance imaging apparatus 100.

A static magnetic field magnet 1 is formed in a hollow cylindrical shape and generates a uniform static magnetic field in a space thereof. The static magnetic field magnet 1 is, for example, a permanent magnet or a superconductive magnet. A gradient magnetic field coil 2 is formed in a hollow cylindrical shape and generates a gradient magnetic field in a space thereof.

Specifically, the gradient magnetic field coil 2 is positioned inside of the static magnetic field magnet 1 and generates a gradient magnetic field upon reception of supply of a gradient magnetic field pulse from a gradient magnetic field power supply 3. The gradient magnetic field power supply 3 supplies a gradient magnetic field pulse to the gradient magnetic field coil 2 according to a control signal transmitted from sequence control circuitry 10.

A bed 4 includes a top panel 4a on which the subject P is placed, and the top panel 4a is inserted into the cavity of the gradient magnetic field coil 2 as an imaging port, in a state where the subject P is placed thereon. Generally, the bed 4 is installed so that the longitudinal direction becomes parallel to the central axis of the static magnetic field magnet 1.

Bed control circuitry 5 drives the bed 4 to move the top panel 4a in the longitudinal direction and the vertical direction.

A transmitter coil 6 generates a magnetic field. Specifically, the transmitter coil 6 is positioned inside of the gradient magnetic field coil 2 and generates a magnetic field upon reception of supply of an RF (Radio Frequency) pulse from transmitter circuitry 7. The transmitter circuitry 7 supplies an RF pulse corresponding to a Larmor frequency to the transmitter coil 6, according to a control signal transmitted from the sequence control circuitry 10.

A receiver coil 8 receives a magnetic resonance (hereinafter, MR) signal. Specifically, the receiver coil 8 is positioned inside of the gradient magnetic field coil 2 and receives a magnetic resonance signal emitted from the subject P due to an influence of a magnetic field. The receiver coil 8 also outputs the received magnetic resonance signal to receiver circuitry 9.

The receiver circuitry 9 generates magnetic resonance signal data based on the magnetic resonance signal output from the receiver coil 8, according to a control signal transmitted from the sequence control circuitry 10. Specifically, the receiver circuitry 9 generates magnetic resonance signal data by converting the magnetic resonance signal output from the receiver coil 8 into a digital signal, and transmits the generated magnetic resonance signal data to an image processing apparatus 200 through the sequence control circuitry 10. The receiver circuitry 9 can be provided on a side of a pedestal device including the static magnetic field magnet 1 and the gradient magnetic field coil 2.

The sequence control circuitry 10 controls the gradient magnetic field power supply 3, the transmitter circuitry 7, and the receiver circuitry 9. Specifically, the sequence control circuitry 10 transmits a control signal based on pulse-sequence execution data transmitted from the image processing apparatus 200 to the gradient magnetic field power supply 3, the transmitter circuitry 7, and the receiver circuitry 9. For example, the sequence control circuitry 10 is an integrated circuit such as an ASIC (Application Specific Integrated Circuit) or an FPGA (Field Programmable Gate Array), or an electronic circuit such as a CPU (Central Processing unit) or an MPU (Micro Processing Unit).

The image processing apparatus 200 includes processing circuitry 150, a memory 132, an input interface 134, and a display 135. The processing circuitry 150 has a control function 150a, a generation function 150b, a setting function 150c, a presentation function 150d, a receiver function 150e, and the like.

Respective processing functions performed by the control function 150a, the generation function 150b, the setting function 150c, the presentation function 150d, and the receiver function 150e are stored in the memory 132 in a format of a computer executable program. The processing circuitry 150 is a processor that reads a program from the memory 132 and executes the program to realize a function corresponding to the respective programs. In other words, the processing circuitry 150 in a state where the respective programs have been read has the respective functions illustrated in the processing circuitry 150 in FIG. 1. In FIG. 1, it is described that the single processing circuitry 150 realizes the processing functions performed by the control function 150a, the generation function 150b, the setting function 150c, the presentation function 150d, and the receiver function 150e. However, a plurality of independent processors can be combined to constitute the processing circuitry 150, and the respective processors execute the respective programs to realize the respective functions.

In other words, there are a case where the respective functions described above are configured as respective programs and one processing circuit executes the respective programs, and a case where a specific function is implemented in a dedicated independent program execution circuit. The control function 150a, the generation function 150b, the setting function 150c, the presentation function 150d, and the receiver function 150e provided in the processing circuitry 150 are respectively an example of a control unit, a generation unit, a setting unit, a presentation unit, and a receiver unit. Further, the sequence control circuitry 10 is an example of a sequence control unit.

The term "processor" used in the above descriptions means, for example, a CPU (Central Processing unit), a GPU (Graphical Processing Unit), or a circuit such as an application specific integrated circuit (ASIC), a programmable logic device (for example, a simple programmable logic device (SPLD), a complex programmable logic device (CPLD), and a field programmable gate array (FPGA). The processor reads a program stored in the memory 132 and executes the program to realize the functions thereof. Instead of storing the program in the memory 132, it can be configured to install the program directly in the circuit of the processor. In this case, the processor reads and executes the program installed in the circuit to realize the functions. The memory 132 is, for example, a semiconductor memory element such as a RAM (Random Access Memory) or a flash memory, a hard disk, or an optical disk.

The memory 132 stores therein image data stored by the generation function 150b, and other pieces of data to be used in the magnetic resonance imaging apparatus 100. The memory 132 is configured by, for example, a semiconductor memory element such as a RAM (Random Access Memory) or a flash memory, a hard disk, or an optical disk.

The input interface 134 receives inputs of various instructions and pieces of information from an operator. The input interface 134 is, for example, a pointing device such as a mouse or a trackball, or an input device such as a keyboard.

The display 135 displays thereon various pieces of information such as image data under control of the processing circuitry 150. The display 135 is, for example, a display device such as a liquid crystal display.

The processing circuitry 150 is connected to the sequence control circuitry 10 by an interface function (not illustrated), and controls input and output of data transmitted and received between the sequence control circuitry 10 and the image processing apparatus 200.

The processing circuitry 150 executes overall control of the magnetic resonance imaging apparatus 100 by the control function 150a, thereby controlling imaging, image generation, and image display. For example, the control function 150a is an integrated circuit such as an ASIC or an FPGA, or an electronic circuit such as a CPU or an MPU.

The processing circuitry 150 reconfigures image data from the magnetic resonance signal data transmitted from the sequence control circuitry 10, and stores the reconfigured image data in the memory 132. The processing circuitry 150 sets imaging conditions of a pulse sequence based on, for example, information on heartbeats or pulsebeats of a subject, or information on the T₁ value of an imaging target. The processing performed by the generation function 150b, the setting function 150c, the presentation function 150d, and the receiver function 150e is described later.

A background of the first embodiment is briefly described next.

It is considered that the T₁ map displaying the T₁ value of a tissue is effective for diagnosis of, for example, diffuse myocardial fibrosis. As the magnetic resonance imaging method for generating the T₁ map, for example, there is MOLLI (modified Look-Locker Inversion Recovery) method. In this method, an inversion pulse is applied for multiple times in a predetermined pattern such as 3, 3, 5 described later to perform a data collection for multiple times by changing TI (Inversion Time). In this case, the pattern by which a data collection is performed for multiple times means a pattern defining a relation between heartbeats or pulsebeats, an inversion pulse, and a data collection timing, the pattern being an imaging condition of a pulse sequence to collect pieces of data at a plurality of timings along a relaxation curve of longitudinal magnetization in synchronization with heartbeats or pulsebeats. A flip angle of the inversion pulse to be applied in the first embodiment is not limited to 180 degrees. As an example, the flip angle of the inversion pulse can be an angle from 90 degrees to 180 degrees inclusive, or an angle equal to or larger than 180 degrees. The inversion pulse typically causes longitudinal magnetization of the tissue to be inverted between a positive value and a negative value.

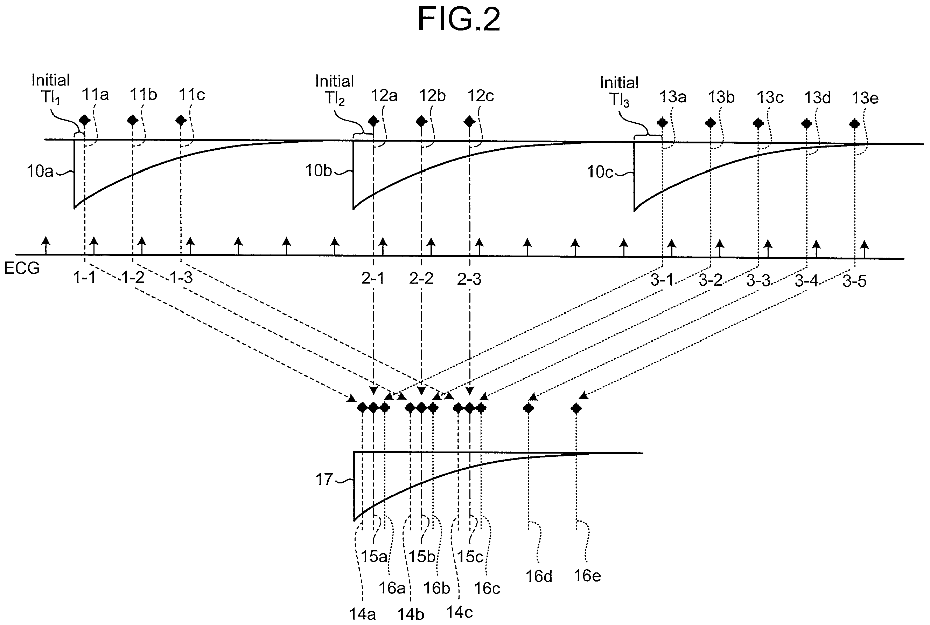

FIG. 2 is an explanatory diagram of a background of the magnetic resonance imaging apparatus according to the first embodiment. Specifically, FIG. 2 illustrates an example of a pulse sequence to be applied by the sequence control circuitry 10, when setting based on the heart rate and the T₁ value described later is not performed.

In the upper part of FIG. 2, a horizontal axis denotes a time. Inversion pulses 10a, 10b, and 10c indicate inversion pulses applied by the sequence control circuitry 10. In the upper part of FIG. 2, a time change curve of longitudinal magnetization that changes due to these inversion pulses is illustrated. Data collections 11a, 11b, 11c, 12a, 12b, 12c, 13a, 13b, 13c, 13d, and 13e indicate the timing at which a data collection is performed. In this example, a data collection is performed three times with respect to the inversion pulse 10a, a data collection is performed three times with respect to the inversion pulse 10b, and a data collection is performed five times with respect to the inversion pulse 10c. In the MOLLI method, a collection is typically performed in this manner in a pattern "3, (3), 3, (3), 5", while gradually changing an application timing of the inversion pulse. The "3, (3), 3, (3), 5" means a pattern in which after a collection has been performed for three heartbeats, there is a period during which a collection is not performed for three heartbeats, then after a collection has been performed for three heartbeats, there is a period during which a collection is not performed for three heartbeats, and lastly, a collection is performed for five heartbeats. These collections are performed in electrocardiographic synchronization, for example, in the same cardiac phase.

The lower part of FIG. 2 illustrates the data in the upper part of FIG. 2 by coordinating and integrating the data, using an application time of the inversion pulse as an origin. The inversion pulse 17 represents an inversion pulse. Data collections 14a, 14b, 14c, 15a, 15b, 15c, 16a, 16b, 16c, 16d, and 16e respectively correspond to the data collections 11a, 11b, 11c, 12a, 12b, 12c, 13a, 13b, 13c, 13d, and 13e in the upper part. In this manner, by performing data collections at a plurality of TIs (a time from an application of the inversion pulse until a data collection is performed), the T₁ map can be generated.

However, the MOLLI method is susceptible to, for example, a heart rate or a pulse rate. Therefore, if the heart rate or the pulse rate changes, the accuracy of the measured T₁ value may decrease, or a breath holding time may become long more than necessary.

For example, if the heart rate or the pulse rate is too low, an application interval of the inversion pulse becomes too long. Therefore, although the longitudinal magnetization is sufficiently relaxed, the next inversion pulse is not applied, thereby generating a waste of time. As a result, the breath holding time increases. Further, for example, the time between the data collection 16a and the data collection 16b increases. As a result, sampling cannot be performed at a time at which a relaxation curve changes most rapidly, and the accuracy of the measured T₁ value decreases.

On the other hand, if the heart rate or the pulse rate is too high, the application interval of the inversion pulse becomes too short, and although the longitudinal magnetization is not sufficiently relaxed, the next inversion pulse is applied, so that the accuracy of the measured T₁ value is decreased. Further, the longest TI value in which a data collection is performed (for example, the data collection 16e) becomes small. As a result, a data collection cannot be performed sufficiently during the long TI, and the accuracy of the measured T₁ value decreases.

Under such a background, the magnetic resonance imaging apparatus 100 according to the first embodiment sets a pattern of a pulse sequence to be applied based on the information on the heartbeats of the subject P, by the setting function 150c provided in the processing circuitry 150. Accordingly, a data collection can be performed efficiently.

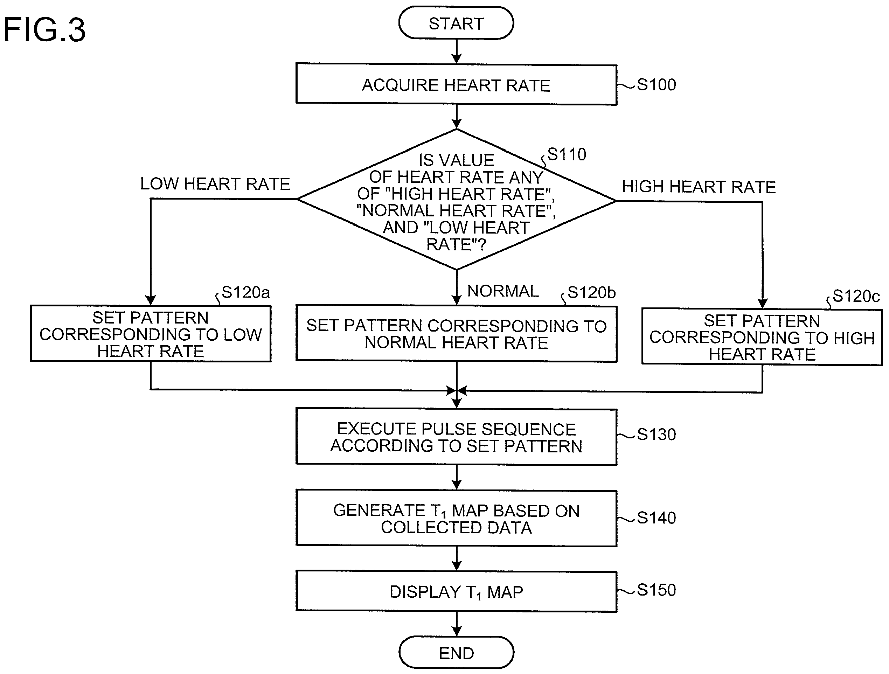

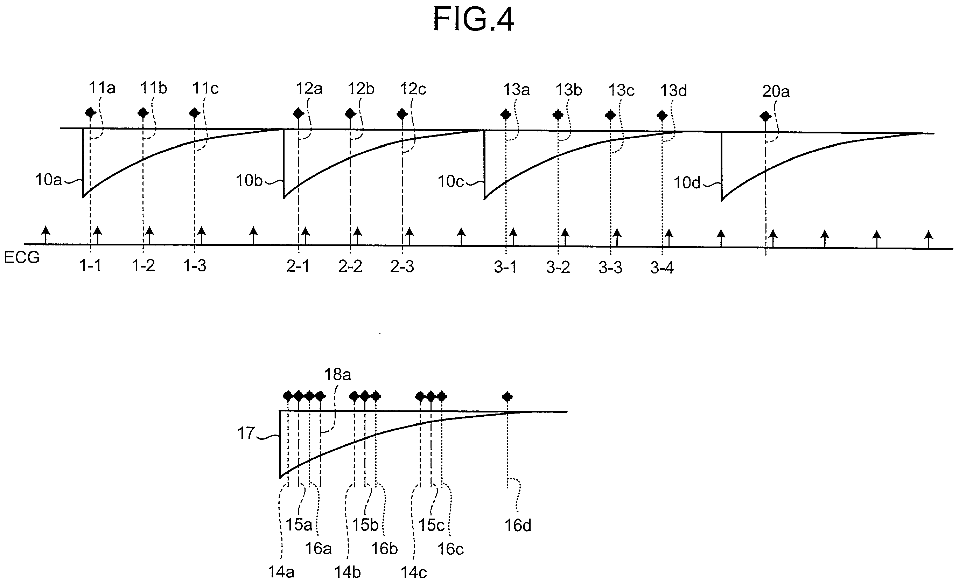

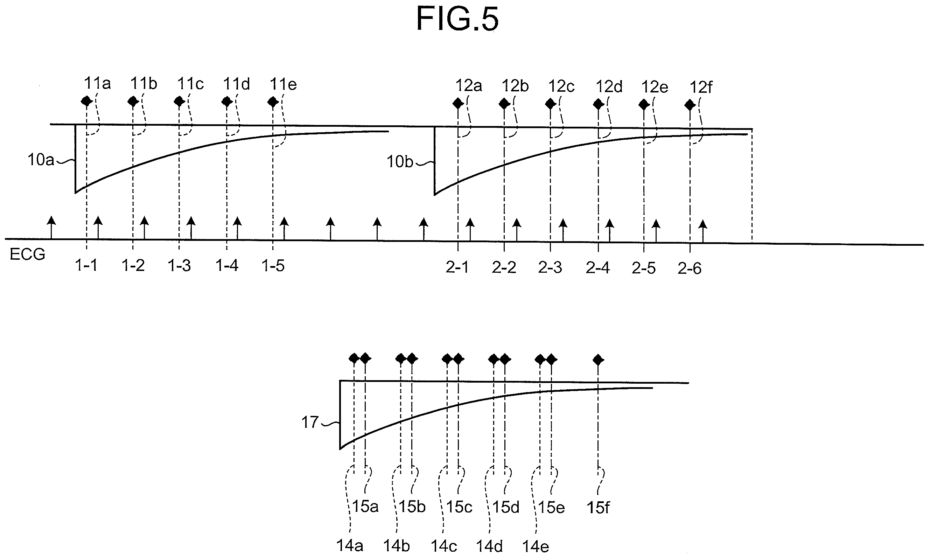

The configuration is described with reference to FIG. 3 to FIG. 5. FIG. 3 is a flowchart for explaining a flow of processing performed by the magnetic resonance imaging apparatus according to the first embodiment. FIG. 4 and FIG. 5 are explanatory diagrams of the processing performed by the magnetic resonance imaging apparatus according to the first embodiment. More specifically, FIG. 4 illustrates a case corresponding to "low heart rate", and FIG. 5 illustrates a case corresponding to "high heart rate". In the following descriptions, such as in the first and second embodiments, examples of heartbeats and heart rates are described. However, the embodiments can be similarly applied to a case of pulsebeats and pulse rates.

The flow of the processing performed by the magnetic resonance imaging apparatus 100 is described below with reference to FIG. 3.

First, the processing circuitry 150 acquires the heart rate of the subject P (Step S100). For example, the processing circuitry 150 acquires the heart rate of the subject P based on an electric signal acquired through an electrode (not illustrated) attached to the subject P. Subsequently, the processing circuitry 150 compares the heart rate acquired at Step S100 with a predetermined value, to determine which of "high heart rate", "normal heart rate", and "low heart rate" the value of the heart rate is (Step S110) . For example, if the value of the heart rate is larger than a first value, the processing circuitry 150 determines that "heart rate is high". If the value of the heart rate does not exceed the first value but is larger than a second value being smaller than the first value, the processing circuitry 150 determines that "heart rate is normal". If the value of the heart rate does not exceed the second value, the processing circuitry 150 determines that "heart rate is low". For example, if the value of the heart rate is higher than 80 bmp, the processing circuitry 150 determines that "heart rate is high". If the value of the heart rate is from 60 bmp to 80 bmp, the processing circuitry 150 determines that "heart rate is normal". If the value of the heart rate is lower than 60 bmp, the processing circuitry 150 determines that "heart rate is low".

At Step S110, if the processing circuitry 150 determines that the heart rate of the subject P is "low heart rate", the processing proceeds to Step S120a, and the processing circuitry 150 sets a pattern corresponding to the low heart rate. At Step S110, if the processing circuitry 150 determines that the heart rate of the subject P is "normal heart rate", the processing proceeds to Step S120b, and the processing circuitry 150 sets a pattern corresponding to the normal heart rate. At Step S110, if the processing circuitry 150 determines that the heart rate of the subject P is "high heart rate", the processing proceeds to Step S120c, and the processing circuitry 150 sets a pattern corresponding to the high heart rate.

The "pattern corresponding to the normal heart rate" is a pulse sequence of, for example, the MOLLI method illustrated in FIG. 2. The "pattern corresponding to the low heart rate" and the "pattern corresponding to the high heart rate" are pulse sequences, for example, illustrated in FIG. 4 and FIG. 5, respectively.

The pattern when the heart rate is low is described first.

In FIG. 4, a horizontal axis denotes a time. In the upper part of FIG. 4, inversion pulses 10a, 10b, 10c, and 10d indicate inversion pulses to be applied by the sequence control circuitry 10. Data collections 11a, 11b, 11c, 12a, 12b, 12c, 13a, 13b, 13c, 13d, and 20e indicate the timing at which the sequence control circuitry 10 performs a data collection. The lower part of FIG. 4 illustrates the pulse sequence in the upper part of FIG. 4 by coordinating the pulse sequence, using the application time of the inversion pulse as an origin. Data collections 14a, 14b, 14c, 15a, 15b, 15c, 16a, 16b, 16c, 16d, and 18a respectively correspond to the data collections 11a, 11b, 11c, 12a, 12b, 12c, 13a, 13b, 13c, 13d, and 20a in the upper part.

The pattern in FIG. 4 is a pattern "3, (1), 3, (1), 4, (1), 1", and is a pattern set such that, for example, when the heart rate is low, the time interval between the inversion pulses to be applied becomes shorter as compared to the pattern "3, (3), 3, (3), 5" corresponding to the normal heart rate illustrated in FIG. 2. At Step S120a, if the heart rate of the patient falls below a predetermined threshold, the processing circuitry 150 performs setting by the setting function 150c so that the number of dummy RRs as a period during which a data collection is not performed becomes smaller (the period in which a data collection is not performed becomes short), as compared to a case where the heart rate of the subject P does not fall below the predetermined threshold. For example, in the case of FIG. 4, the number of dummy RRs is 3, which is fewer than the case in FIG. 2 in which the number of dummy RRs is 6. Further, for example, when the heart rate of the subject falls below a predetermined threshold, there may be a case where the time interval between the inversion pulses to be applied becomes shorter, as compared to the case where the heart rate of the subject does not fall below the predetermined threshold. For example, the processing circuitry 150 performs setting so that the time interval between the inversion pulse 10a and the inversion pulse 10b becomes shorter than the case illustrated in FIG. 2, as illustrated in FIG. 4. In other words, when the heart rate (or the pulse rate) of the subject falls below a predetermined threshold, the processing circuitry 150 performs setting by the setting function 150c so that the heart rate or the pulse rate between the inversion pulses becomes smaller as compared to the case where the heart rate (or the pulse rate) of the subject does not fall below the predetermined threshold.

Further, the pattern in FIG. 4 is a pattern in which the number of applications of inversion pulses is larger in one repetition period, as compared to the pattern corresponding to the normal heart rate. In other words, at Step S120a, when the heart rate of the subject falls below a predetermined threshold, the processing circuitry 150 performs setting by the setting function 150c so that the number of applications of the inversion pulses in one repetition period becomes larger, as compared to a case where the heart rate of the subject does not fall below the predetermined threshold. For example, in one repetition period, the number of applications of the inversion pulses is four in FIG. 4, whereas the number of applications of the inversion pulses is three in FIG. 2.

Further, in the pattern in FIG. 4, the number of data collections per one inversion pulse is fewer than the pattern corresponding to the normal heart rate. In other words, at Step S120a, when the heart rate of the subject falls below a predetermined threshold, the processing circuitry 150 performs setting by the setting function 150c so that the number of data collections per one inversion pulse becomes fewer than the case where the heart rate of the subject does not fall below the predetermined threshold. For example, a collection corresponding to the inversion pulse 10c is performed four times in FIG. 4, whereas it is five times in FIG. 2.

Further, in the pattern in FIG. 4, the breath holding time can be shortened as compared to the pattern corresponding to the normal heart rate. In other words, at Step S120a, when the heart rate of the subject falls below a predetermined threshold, the processing circuitry 150 can perform setting by the setting function 150c, so that the breath holding time becomes shorter than the case where the heart rate of the subject does not fall below the predetermined threshold. For example, the processing circuitry 150 can shorten the breath holding time by using the pattern requiring 14 heartbeats "3, (1), 3, (1), 4, (1), 1" as illustrated in FIG. 4, instead of the pattern requiring 17 heartbeats "3, (3), 3, (3), 5" in FIG. 2.

The reason for the processing circuitry 150 performing such setting is as follows.

First, when the heart rate of the subject falls below a predetermined threshold, an R-R interval is increased. In this case, during a dummy cycle for three heartbeats after the first collection has been performed among the pattern of, for example, "3, (3), 3, (3), 5" in FIG. 2, there is an instance where longitudinal magnetization is completely recovered. In such a case, it is a waste of time to insert the dummy cycle for three heartbeats. Therefore, in order to shorten the breath holding time, the processing circuitry 150 reduces the number of dummy cycles by the setting function 150c. As an example, the processing circuitry 150 performs setting so that the time interval between inversion pulses to be applied becomes short. Further, the processing circuitry 150 can perform setting such that not only the dummy cycle but also the number of data collections per one inversion pulse decreases. By performing such setting, the breath holding time can be shortened.

Further, when the breath holding time is maintained the same, the processing circuitry 150 can perform setting to increase the number of applications of the inversion pulses by reducing the time interval between the inversion pulses. That is, as a result of increase in the number of applications of the inversion pulses, the measurement accuracy of the T₁ value is improved.

Secondly, when the heart rate of the subject falls below a predetermined threshold, the R-R interval is increased. However, as a result, the time interval of the TI time between the collected data points also increases. For example, in FIG. 2, the time interval between the data collection 16a and the data collection 14b also increases. As a result, the accuracy of curve fitting of the T₁ relaxation time decreases.

Under such a background, the processing circuitry 150 performs setting to perform the data collection 18a newly, in order to suppress the influence of the increase of the time interval between the data collection 16a and the data collection 14b in FIG. 4. That is, the processing circuitry 150 sets to perform the data collection 20a newly, which is a collection corresponding to the data collection 18a. In this example, the processing circuitry 150 can perform the data collection 20a without increasing, for example, the breath holding time by reducing, for example, the application interval of the inversion pulse.

Next, a pattern when a heart rate is high is described with reference to FIG. 5.

In FIG. 5, a horizontal axis denotes a time. In the upper part of FIG. 5, inversion pulses 10a and 10b indicate inversion pulses to be applied by the sequence control circuitry 10. Data collections 11a, 11b, 11c, 11d, 11e, 12a, 12b, 12c, 12d, 12e, and 12f indicate the timing at which the sequence control circuitry 10 performs a data collection. The lower part of FIG. 5 illustrates the pulse sequence in the upper part of FIG. 5 by coordinating the pulse sequence, using the application time of the inversion pulse as an origin. The inversion pulse 17 represents an inversion pulse. Data collections 14a, 14b, 14c, 14d, 14e, 15a, 15b, 15c, 15d, 15e, and 15f respectively correspond to the data collections 11a, 11b, 11c, 11d, 11e, 12a, 12b, 12c, 12d, 12e, and 12f in the upper part.

In this case, the pattern in FIG. 5 is a pattern "5, (3), 6", and is a pattern set so that the time interval between the inversion pulses to be applied becomes longer than the pattern "3, (3), 3, (3), 5" corresponding to the normal heart rate illustrated in FIG. 2. In other words, at Step S120c, when the heart rate of the subject exceeds a predetermined threshold, the processing circuitry 150 performs setting by the setting function 150c so that the time interval between the inversion pulses to be applied becomes longer than the case where the heart rate of the subject does not exceed the predetermined threshold. For example, the processing circuitry 150 performs setting as illustrated in FIG. 5 so that the time interval between the inversion pulse 10a and the inversion pulse 10b becomes longer than the time interval illustrated in FIG. 2.

Further, the pattern in FIG. 5 is a pattern in which the number of applications of the inversion pulses in one repetition period is fewer than the pattern corresponding to the normal heart rate. In other words, at Step S120c, if the heart rate of the subject exceeds a predetermined threshold, the processing circuitry 150 performs setting by the setting function 150c so that the number of applications of the inversion pulses in one repetition period becomes smaller as compared to a case where the heart rate of the subject does not exceed the predetermined threshold. For example, in one repetition period, the number of applications of the inversion pulses is two in FIG. 5, whereas it is three in FIG. 2.

Further, in the pattern in FIG. 5, the number of data collections per one inversion pulse is larger, as compared to the pattern corresponding to the normal heart rate. In other words, at Step S120c, if the heart rate of the subject exceeds a predetermined threshold, the processing circuitry 150 performs setting by the setting function 150c so that the number of data collections per one inversion pulse becomes larger as compared to a case where the heart rate of the subject does not exceed the predetermined threshold. For example, a collection corresponding to the inversion pulse 10a is performed five times in FIG. 5, whereas it is three times in FIG. 2. In other words, if the heart rate (or the pulse rate) of the subject exceeds a predetermined threshold, the processing circuitry 150 performs setting by the setting function 150c so that the number of heartbeats (or the pulsebeats) between inversion pulses becomes larger as compared to the case where the heart rate (or the pulse rate) of the subject does not exceed the predetermined threshold.

In the pattern in FIG. 5, the breath holding time is shorter than the pattern corresponding to the normal heart rate. In other words, at Step S120c, if the heart rate of the subject exceeds a predetermined threshold, the processing circuitry 150 can perform setting by the setting function 150c so that the breath holding time becomes shorter as compared to the case where the heart rate of the subject does not exceed the predetermined threshold. For example, the processing circuitry 150 can reduce the breath holding period by using a pattern "5, (3), 6" requiring 14 heartbeats as illustrated in FIG. 5, instead of the pattern "3, (3), 3, (3), 5" requiring 17 heartbeats as illustrated in FIG. 2.

The reason for the processing circuitry 150 performing such setting is as follows.

First, if the heart rate of the subject exceeds a predetermined threshold, the R-R interval is shortened. In this case, there is an instance where longitudinal magnetization is completely recovered during a dummy cycle for three heartbeats after the first collection has been performed, among the pattern of, for example, "3, (3), 3, (3), 5" in FIG. 2. In this case, it is desired to delay the application timing of an inversion pulse. Therefore, the processing circuitry 150 performs setting by the setting function 150c so that the time interval between inversion pulses to be applied increases. If the time interval between the inversion pulses to be applied increases, the processing circuitry 150 can perform further a data collection by using the increased time. That is, the processing circuitry 150 can perform setting to increase the number of data collections per one inversion pulse. Further, as a result of increase of the time interval between inversion pulses, the number of applications of the inversion pulses decreases in one repetition period.

Secondly, if the heart rate of the subject exceeds a predetermined threshold, the R-R interval is shortened. However, as a result, the collected data points concentrate on a portion having a small TI and, on the contrary, the number of data points having a large TI value decreases. Accordingly, a decrease in the number of data points in a portion having a large TI value causes a decrease at the accuracy of curve fitting of T₁ calculation.

Under such a background, the processing circuitry 150 can collect data at the data points having a small TI value and the data points having a large TI value with good balance by increasing the number of collections per one inversion pulse, and can maintain the accuracy of curve fitting. In this manner, by performing any of the processes at Steps S120a to S120c, the processing circuitry 150 applies the inversion pulse at a plurality of first times by the setting function 150c, and sets the imaging conditions of the pulse sequence for collecting data at a plurality of second times in electrocardiographic synchronization, based on the information on the heartbeats or pulsebeats of the subject P. In other words, the processing circuitry 150 sets by the setting function 150c a pattern based on the information on the heartbeats or pulsebeats of the subject, the pattern being the imaging condition of the pulse sequence for collecting data at a plurality of timings along the relaxation curve of longitudinal magnetization in synchronization with the heartbeats or pulsebeats and the pattern defining a relation between the heartbeats or pulsebeats, the inversion pulse, and the data collection timing. Further, the sequence control circuitry 10 controls execution of the pulse sequence according to the pattern.

As an example of the pulse sequence, for example, the pulse sequence of the MOLLI method can be mentioned. In this example, "to set the imaging conditions" means, for example, to set the plurality of first times and the plurality of second times. The first times are, for example, times corresponding to the inversion pulses 10a, 10b, 10c, and 10d in FIG. 4, and the second times are, for example, times corresponding to the data collections 11a, 11b, 11c, and 12a in FIG. 4. The processing circuitry 150 can set the imaging conditions based on the information on the heartbeats (or the information on the pulsebeats) of the subject P, by designating the number of applications of the inversion pulse and the number of data collections per one inversion pulse. The description of setting of the imaging conditions is not limited to the first embodiment, and is also applicable to the second embodiment and onwards.

Subsequently, the processing circuitry 150 transmits the imaging conditions set at any of Steps S120a to S120c to the sequence control circuitry 10. The sequence control circuitry 10 having received the imaging conditions set by the processing circuitry 150 executes the pulse sequence by using the received imaging conditions (Step S130). The processing circuitry 150 acquires data related to the plurality of TIs based on the pulse sequence executed by the sequence control circuitry 10. The processing circuitry 150 performs curve fitting and other processing to the acquired data related to the plurality of TIs to generate the T₁ map by the generation function 150b (Step S140). The processing circuitry 150 causes the display 135 to display the generated T₁ map by the control function 150a. The display 135 displays the generated T₁ map (Step S150).

In the first embodiment, the processing circuitry 150 sets the pattern of the pulse sequence based on the information on the heartbeats or pulsebeats of the subject P by the setting function 150c. Accordingly, the magnetic resonance imaging apparatus 100 can efficiently perform a data collection for generating the T₁ map.

### Second embodiment

In the first embodiment, there has been described a case where the processing circuitry 150 sets imaging conditions of a pulse sequence (performs pattern setting of a pulse sequence) based on information on the heartbeats or pulsebeats of the subject P. In the second embodiment, the processing circuitry 150 sets the imaging conditions of a pulse sequence based on information on the T₁ value of an imaging target.

Specifically, when the T₁ value of the imaging target is small, the imaging target is magnetically relaxed in a short time. Accordingly, the processing circuitry 150 sets a pulse sequence of the pattern similar to a pattern when the heart rate is relatively small described in the first embodiment (for example, the pulse sequence illustrated in FIG. 4), and the sequence control circuitry 10 executes the pulse sequence based on the set pattern.

On the other hand, when the T₁ value of the imaging target is large, it takes a long time for the imaging target to magnetically relax. Accordingly, the processing circuitry 150 sets the pulse sequence similar to the case having a relatively large heart rate described in the first embodiment (for example, the pulse sequence illustrated in FIG. 5), and the sequence control circuitry 10 executes the pulse sequence based on the set pattern.

In this manner, the processing circuitry 150 sets the pattern of the pulse sequence corresponding to the T₁ value of the imaging target, thereby enabling to collect pieces of data efficiently for creating the T₁ map.

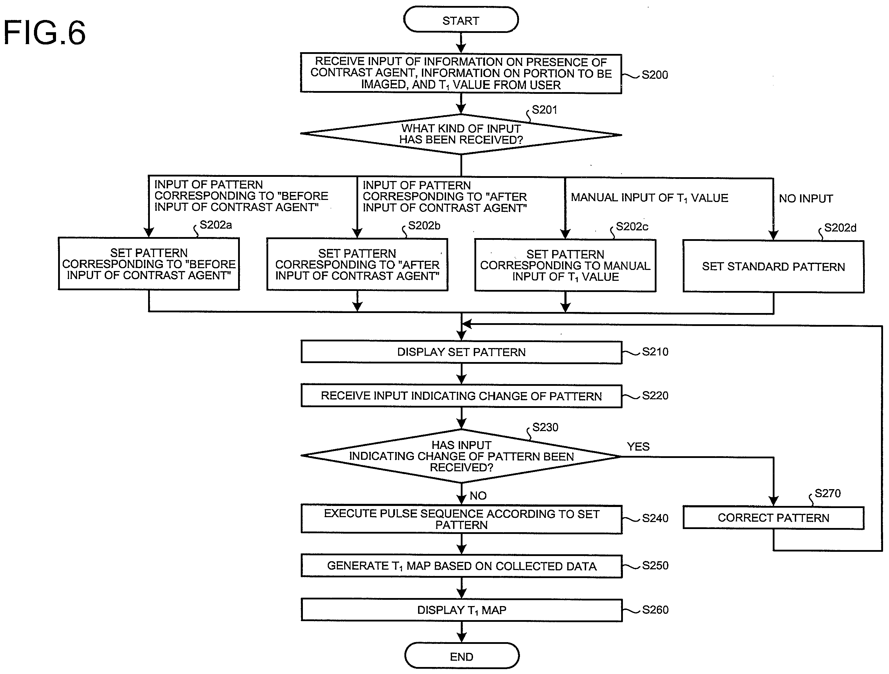

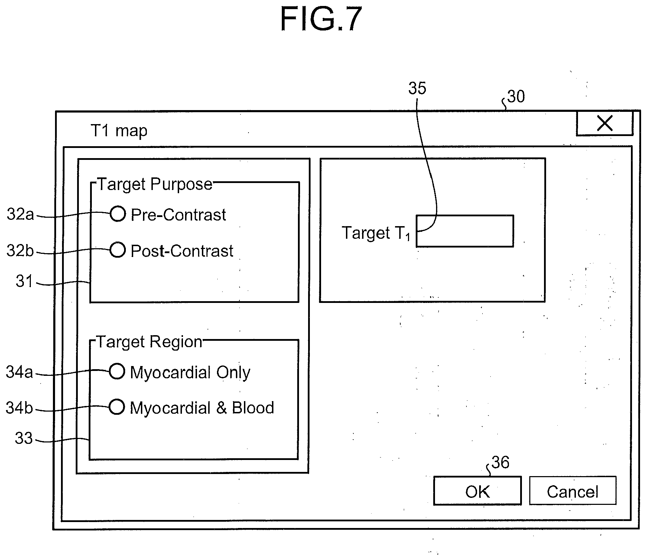

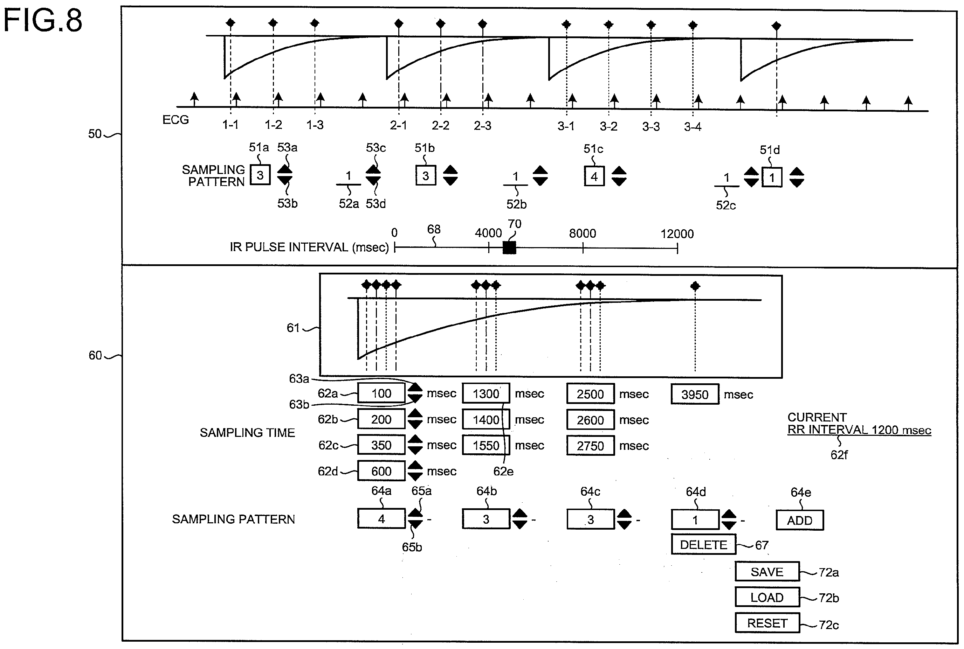

The processing performed by the magnetic resonance imaging apparatus 100 according to the second embodiment is described with reference to FIGS. 6 to 8. FIG. 6 is a flowchart for explaining a flow of processing performed by the magnetic resonance imaging apparatus according to the second embodiment. FIGS. 7 and 8 are explanatory diagrams of an example of a user interface according to the magnetic resonance imaging apparatus according to the second embodiment.

The processing circuitry 150 first receives an input of information on the T₁ value of an imaging target, for example, information on the presence or absence of a contrast agent, information on a body part to be imaged, and the T₁ value from a user by the receiver function 150e, for example, through the display 135 (Step S200). Because the T₁ value of the imaging target largely changes due to, for example, the presence or absence of the contrast agent, the information on the presence or absence of the contrast agent is information on the T₁ value of the imaging target. Because the T₁ value of the imaging target largely changes according to the body part to be imaged and a body part to be focused (for example, whether to focus on only a myocardium or focus on both the myocardium and blood), these pieces of information are information on the T₁ value of the imaging target.

FIG. 7 illustrates an example of an input interface at Step S200. A display area 30 is a user interface in which the display 135 receives an input of the information on the T₁ value of the imaging target from a user.

A display area 31 is a user interface in which the display 135 receives an input of the information on the presence or absence of the contrast agent from the user. In the display area 31, buttons 32a and 32b are buttons for the display 135 to receive an input indicating that the imaging target is "before input of contrast agent" and "after input of contrast agent" respectively from the user.

A display area 33 is a user interface in which the display 135 receives the information on the body part to be imaged from the user. Buttons 34a and 34b are buttons for the display 135 to receive an input indicating that the body part to be imaged is "only myocardium" or "both myocardium and blood" respectively from the user.

An input field 35 is for the display 135 to receive an input of the T₁ value from a user. An OK button 36 is a button for confirming an input result from a user.

At Step S200, when a user selects the OK button 36 after selecting the button 32a, the display 135 receives an input indicating that the imaging target is "before input of contrast agent". When the user selects the OK button 36 after selecting the button 32b, the display 135 receives an input indicating that the imaging target is "after input of contrast agent". When the user selects the OK button 36 after selecting the button 34a, the display 135 receives an input indicating that the body part to be imaged is "only myocardium". When the user selects the OK button 36 after selecting the button 34b, the display 135 receives an input indicating that the body part to be imaged is "both myocardium and blood". When the user selects the OK button 36 after an input of the T₁ value into the input field 35, the display 135 receives the input T₁ value.

Subsequently, the processing circuitry 150 determines what kind of input the display 135 has received at Step S200 (Step S201).

When the display 135 receives an input indicating that the imaging target is "before input of contrast agent" through the button 32a at Step S200, the process proceeds to Step S202a, and the processing circuitry 150 sets the pattern of the pulse sequence corresponding to "before input of contrast agent" by the setting function 150c. When the display 135 receives an input indicating that the imaging target is "after input of contrast agent" through the button 32b at Step S200, the process proceeds to Step S202b, and the processing circuitry 150 sets the pattern of the pulse sequence corresponding to "after input of contrast agent" by the setting function 150c. When the display 135 receives an input of the T₁ value of the imaging target through the input field 35 at Step S200, the process proceeds to Step S202c, and the processing circuitry 150 sets the pattern of the pulse sequence corresponding to the manually input T₁ value by the setting function 150c at Step S200. If there is no particular input at Step S200, the process proceeds to Step S202d, and the processing circuitry 150 sets the pattern of the standard pulse sequence by the setting function 150c.

The patterns of the pulse sequence set by the processing circuitry 150 at Steps S202a to 202d are described.

At any of Steps S202a to 202d, the processing circuitry 150 first calculates the T₁ value of the imaging target based on the input received from a user at Step S200.

For example, in the case of Step S202a, the processing circuitry 150 calculates the T₁ value of the imaging target before an input of a contrast agent, while referring to an input item regarding the body part to be imaged. For example, when the body part to be imaged input at Step S200 is "only myocardium", the processing circuitry 150 acquires information indicating that the body part to be imaged is "only myocardium" and the T₁ value of the imaging target "before input of contrast agent" from a predetermined table, and calculates the acquired value as the T₁ value. For example, when the body part to be imaged input at Step S200 is "myocardium and blood", the processing circuitry 150 acquires information indicating that the body part to be imaged is "myocardium and blood" and the T₁ value of the imaging target "before input of contrast agent" (for example, an average value of T₁ before input of contrast agent) from the predetermined table, and calculates the acquired value as the T₁ value. The same applies to Step S202b.

In the case of Step S202c, for example, if the T₁ value manually input at Step S200 is not an abnormal value, the processing circuitry 150 calculates the input T₁ value as the T₁ value, and if the input T₁ value is an abnormal value, the processing circuitry 150 prompts the user to re-input the value, and calculates the input value as the T₁ value. In the case of Step S202d, the processing circuitry 150 calculates a default value as the T₁ value.

Subsequently, when the T₁ value of the imaging target is calculated, the processing circuitry 150 sets the pattern of the pulse sequence to be performed at the subsequent stages based on the calculated T₁ value of the imaging target by the setting function 150c at the respective Step S202a to Step S202d.

As described above, if the T₁ value of the imaging target is small, the processing circuitry 150 sets the pulse sequence having the same pattern as the case where the heart rate is relatively low as illustrated in FIG. 4, for example. On the other hand, if the T₁ value of the imaging target is large, the processing circuitry 150 sets a pulse sequence having the same pattern as the case where the heart rate is relatively high as illustrated in FIG. 5, for example.

In other words, if the T₁ value of the imaging target falls below a predetermined threshold, the processing circuitry 150 performs setting by the setting function 150c so that the time interval between inversion pulses to be applied becomes smaller (the number of heartbeats or pulsebeats between inversion pulses becomes smaller), as compared to the case where the T₁ value of the imaging target does not fall below the predetermined threshold. In this case, for example, the processing circuitry 150 sets the pulse sequence of the pattern as illustrated in FIG. 4. The predetermined threshold is, for example, 600 milliseconds.

As an example, the processing circuitry 150 performs setting by the setting function 150c so that the number of applications of inversion pulses increases in one repetition period. For example, the processing circuitry 150 performs setting to add a new inversion pulse and increase the number of pieces of collected data. As another example, the processing circuitry 150 performs setting so that the number of data collections decreases per one inversion pulse. As another example, the processing circuitry 150 performs setting to decrease the number of applications of dummy pulses. As still another example, the processing circuitry 150 can perform setting to decrease the breath holding time.

When the T₁ value of the imaging target exceeds a predetermined threshold, the processing circuitry 150 performs setting by the setting function 150c so that the number of data collections per one inversion pulse becomes larger (the number of heartbeats or pulsebeats becomes larger), as compared to the case where the T₁ value of the imaging target does not exceed the predetermined threshold. In this case, for example, the processing circuitry 150 sets the pulse sequence of the pattern as illustrated in FIG. 5.

As an example, the processing circuitry 150 performs setting by the setting function 150c so that the time interval between inversion pulses to be applied increases. As another example, the processing circuitry 150 performs setting so that the number of applications of the inversion pulses decreases in one repetition period. As still another example, the processing circuitry 150 can perform setting so that the breath holding time becomes short.

The case where the processing circuitry 150 performs setting corresponding to the relative relation between the T₁ value and the heart rate has been described. However, the present embodiment is not limited thereto. As the T₁ value decreases, the accuracy may not become sufficient at the data point where the TI is the lowest. Accordingly, when the T₁ value is lower than a reference threshold, the processing circuitry 150 can set the initial TI value (for example, the TI value corresponding to the data collection 11a in FIG. 2) to a low value by the setting function 150c. In this case, the initial TI value to be set becomes, for example, 50 milliseconds, 150 milliseconds, and 200 milliseconds for each inversion pulse.

In this manner, the processing circuitry 150 sets the imaging conditions by the setting function 150c based on the information with respect to the T₁ value of the imaging target received by the receiver function 150e. In other words, the processing circuitry 150 sets by the setting function 150c a pattern defining the relation between the heartbeats or pulsebeats, the inversion pulse, and the data collection timing, which is the imaging condition of the pulse sequence for collecting data at a plurality of timings along the relaxation curve of longitudinal magnetization in synchronization with the heartbeats or pulsebeats, based on the information on the heartbeats or pulsebeats of the subject.

By performing any of the processes at Steps S202a to S202d, when the processing circuitry 150 sets the pattern of the pulse sequence by the setting function 150c, the processing circuitry 150 causes the display 135 to display the pattern set at any of Steps S202a to S202d by the control function 150a. FIG. 8 illustrates an example of such a GUI. FIG. 8 is an explanatory diagram of the user interface according to the magnetic resonance imaging apparatus according to the second embodiment.

In FIG. 8, a panel 50 displays the pattern of the pulse sequence being currently set along a time axis. Display areas 51a, 51b, 51c, and 51d, and display areas 52a, 52b, and 52c are display areas to display the pattern of the pulse sequence being currently set. For example, in FIG. 8, because the pattern of the pulse sequence being currently set is "3, (1), 3, (1), 4, (1), 1", the display 135 displays "3", "3", "4", and "1" respectively in the display areas 51a, 51b, 51c, and 51d. The display 135 also displays "1", "1", and "1" respectively in the display areas 52a, 52b, and 52c. Buttons 53a, 53b, 53c, and 53d are for the display 135 to receive an input of a change of the pattern of the pulse sequence from a user. A slide bar 68 and a knob 70 are the GUI for the display 135 to receive an input of a change of an application interval of an inversion pulse from the user. When the user scrolls the knob 70 right and left, the display 135 receives an input of the change of the application interval of the inversion pulse.

Meanwhile, the patterns of the pulse sequence being currently set are coordinated based on the application time of respective inversion pulses as an origin, and displayed in a panel 60 together with various control buttons. The patterns of the pulse sequence being currently set are combined together based on the application time of the respective inversion pulses as an origin, and displayed in one diagram in a panel 61. Display areas 62a, 62b, 62c, 62d, and 62e display TI corresponding to respective data collections. For example, in an example illustrated in FIG. 8, the sequence control circuitry 10 performs a data collection at TI=100 milliseconds, 200 milliseconds, 350 milliseconds, 600 milliseconds, 1300 milliseconds, 1400 milliseconds, 1550 milliseconds, 2500 milliseconds, 2600 milliseconds, 2750 milliseconds, and 3950 milliseconds. Buttons 63a and 63b are for the display 135 to receive a change of the TI value (for example, the initial TI) from a user. The current RR interval is displayed in a display area 62f. The TI value other than the initial TI such as 1300 milliseconds is set based on the initial TI value and the current RR interval.

Display areas 64a, 64b, 64c, and 64d display the patterns of the pulse sequence displayed in the panel 61. In the example in FIG. 8, because a data collection is performed at TI=100 milliseconds, 200 milliseconds, 350 milliseconds, 600 milliseconds, 1300 milliseconds, 1400 milliseconds, 1550 milliseconds, 2500 milliseconds, 2600 milliseconds, 2750 milliseconds, and 3950 milliseconds, the sampling pattern becomes "4-3-3-1". Accordingly, the display 135 displays "4", "3", "3", and "1" respectively in the display areas 64a, 64b, 64c, and 64d.

Buttons 65a, 65b, 64e, and 67 are for changing the sampling pattern. For example, when the user clicks the button 65a or 65b, the sampling pattern becomes "5-3-3-1" or "3-3-3-1" respectively. The number of TI groups in which sampling is performed can be also changed. For example, when the user clicks the button 64e or 67, the sampling pattern becomes "4-3-3-1-1" or "4-3-3" respectively.

Buttons 72a, 72b, and 72c are respectively used by the user to save, load, and reset the setting.

Referring back to FIG. 6, at Step S210, the processing circuitry 150 displays by the presentation function 150d the pattern of the pulse sequence set by the processing circuitry 150 at any of Steps S202a to S202d, that is, candidates of the data collection pattern in the pulse sequence on the display 135. For example, the processing circuitry 150 displays by the presentation function 150d the set pattern of the pulse sequence in the panel 50 on the display 135. The processing circuitry 150 displays by the presentation function 150d the set pattern of the pulse sequence in the panel 61 on the display 135 according to a display method in which display is performed based on the application time of the inversion pulse as an origin.

Subsequently, the processing circuitry 150 receives an input of a change of the data collection pattern through the display 135 from a user who has referred to the panel 60 or 61 on the display 135 by the receiver function 150e (Step S220). As an example of receiving an input of the change from the user on the panel 60, for example, the processing circuitry 150 receives an input of the change of the data collection pattern through the buttons 53a, 53b, 53c, and 53d by the receiver function 150e. For example, in the example in FIG. 8, when the user selects the button 53a, the processing circuitry 150 receives an input indicating that the pattern of the pulse sequence is changed from "3, (1), 3, (1), 4, (1), 1" to "4, (1), 3, (1), 4, (1), 1" from the user by the receiver function 150e. When the user selects the button 53c, the processing circuitry 150 receives an input indicating that the pattern of the pulse sequence is changed from "3, (1), 3, (1), 4, (1), 1" to "3, (2), 3, (1), 4, (1), 1" from the user by the receiver function 150e. Further, when the user moves the knob 70 of the slide bar 68 right and left, the processing circuitry 150 receives an input indicating that the application interval of the inversion pulse is changed from the user by the receiver function 150e. The processing circuitry 150 appropriately displays the change performed on the panel 50 by reflecting and linking the change also on and with the panel 60 by the receiver function 150e.

As an example of receiving an input of the change on the panel 61 from the user, the processing circuitry 150 receives an input of a change of the data collection pattern through, for example, the buttons 65a, 65b, 64e, and 67 by the receiver function 150e. For example, when the user respectively selects the buttons 65a, 65b, 64e, and 67, the processing circuitry 150 receives an input indicating that the pattern of the pulse sequence is changed from "4-3-3-1" to "5-3-3-1", "3-3-3-1", "4-3-3-1-1" and "4-3-3" respectively from the user by the receiver function 150e. The processing circuitry 150 receives the TI (for example, the initial TI) of respective data collections through, for example, the button 63a or 63b by the receiver function 150e. The processing circuitry 150 appropriately displays the change performed on the panel 60 by reflecting and linking the change also on and with the panel 50 by the receiver function 150e.

Subsequently, the processing circuitry 150 determines whether an input of a change of the pattern of the pulse sequence has been received through the display 135 (Step S230). If the processing circuitry 150 determines that an input of the change of the pattern of the pulse sequence has been received (YES at Step S230), the processing circuitry 150 having the setting function 150c corrects the pattern of the pulse sequence based on the input received by the receiver function 150e at Step S220 to set the imaging conditions (Step S270). Thereafter, the process returns to Step S210.

On the other hand, if the processing circuitry 150 has not received an input of the change of the pattern of the pulse sequence (NO at Step S230), because there is no particular change in the pattern of the pulse sequence, the sequence control circuitry 10 that has received the imaging conditions set by the processing circuitry 150 executes the pulse sequence by using the received imaging conditions (Step S240). The processing circuitry 150 acquires the data related to a plurality of TIs based on the pulse sequence executed by the sequence control circuitry 10 at Step S240. The processing circuitry 150 performs, by the generation function 150b, curve fitting and other processing with respect to the data related to the acquired TIs to generate the T₁ map (Step S250) . The processing circuitry 150 causes the display 135 to display the generated T₁ map by the control function 150a. The display 135 displays the generated T₁ map (Step S260) .

In the second embodiment, the processing circuitry 150 sets the pattern of a pulse sequence based on the information on the T₁ value of the imaging target by the setting function 150c. Accordingly, the magnetic resonance imaging apparatus 100 can efficiently perform a data collection for generating the T₁ map.

### Third embodiment

In the first embodiment, there has been described a case where the pattern of a pulse sequence is set based on information on the heartbeats or pulsebeats of the subject P. In the second embodiment, there has been described a case where the pattern of a pulse sequence is set based on information on the T₁ value of an imaging target. The embodiment is not limited thereto. The processing circuitry 150 can set the imaging conditions based on the information on the heartbeats of the subject P and the information on the T₁ value of the imaging target by the setting function 150c.

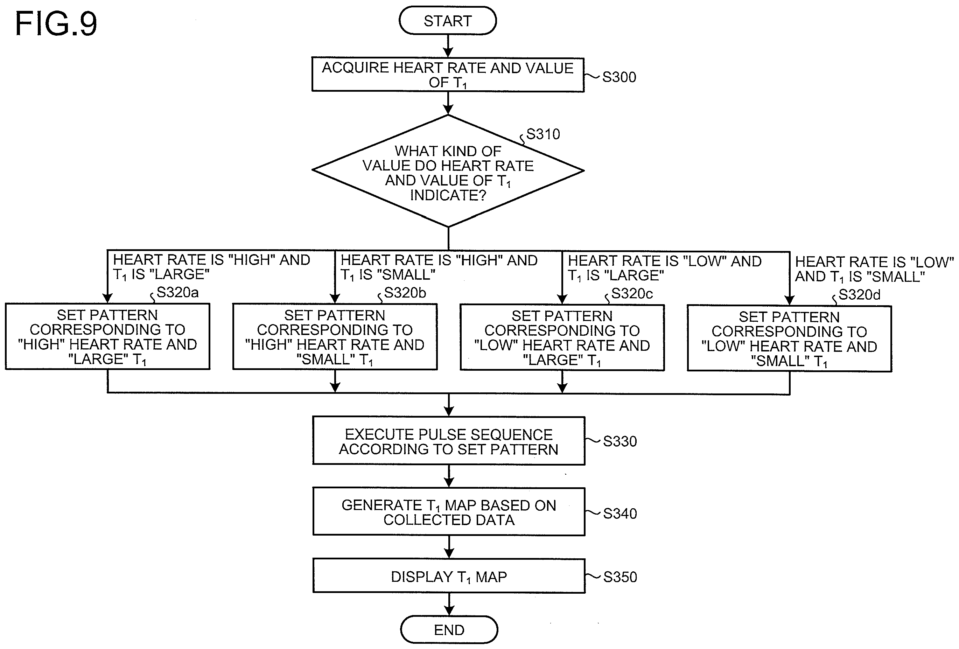

FIG. 9 is a flowchart for explaining a flow of processing performed by a magnetic resonance imaging apparatus according to a third embodiment. First, the processing circuitry 150 acquires a heart rate of the subject P and the T₁ value of an imaging target (Step S300) . As an acquiring procedure of the heart rate of the subject P, the processing circuitry 150 performs a similar process to the process at Step S100 in FIG. 3 described in the first embodiment. As an acquiring procedure of the T₁ value of the imaging target, the processing circuitry 150 performs a similar process to the process at Step S200 in FIG. 6 described in the second embodiment.

Subsequently, the processing circuitry 150 determines whether the heart rate acquired at Step S300 is "high" or "low", and the T₁ value of the imaging target acquired at Step S300 is "large" or "small" (Step S310). For example, if the value of the heart rate exceeds a certain value, the processing circuitry 150 determines that the heart rate is "high", and if the value of the heart rate does not exceed the certain value, the processing circuitry 150 determines that the heart rate is "low". Further, if the T₁ value exceeds a certain value, the processing circuitry 150 determines that the T₁ value is "large", and if the T₁ value does not exceed the certain value, the processing circuitry 150 determines that the T₁ value is "small".

If the processing circuitry 150 determines that the heart rate is "high" and the T₁ value is "large" at Step S310, the process proceeds to Step S320a, and the processing circuitry 150 sets a pattern corresponding to the "high" heart rate and the "large" T₁ value. If the processing circuitry 150 determines that the heart rate is "high" and the T₁ value is "small" at Step S310, the process proceeds to Step S320b, and the processing circuitry 150 sets a pattern corresponding to the "high" heart rate and the "small" T₁ value. If the processing circuitry 150 determines that the heart rate is "low" and the T₁ value is "large" at Step S310, the process proceeds to Step S320c, and the processing circuitry 150 sets a pattern corresponding to the "low" heart rate and the "large" T₁ value. If the processing circuitry 150 determines that the heart rate is "low" and the T₁ value is "small" at Step S310, the process proceeds to Step S320d, and the processing circuitry 150 sets a pattern corresponding to the "low" heart rate and the "small" T₁ value.

As described in the first embodiment, when the heart rate is "low", it is desired to decrease the application interval of the inversion pulse, to decrease the number of data collections per one inversion pulse, and to increase the number of applications of the inversion pulses (the number of times of LL (Looker-Locker) experiments) in one repetition period. On the contrary, when the heart rate is "high", it is desired to increase the application interval of the inversion pulse, to increase the number of data collections per one inversion pulse, and to decrease the number of applications of the inversion pulses (the number of times of LL (Looker-Locker) experiments) in one repetition period.

Further, as described in the second embodiment, when the T₁ value is "small", it is desired to decrease the application interval of the inversion pulse, to decrease the number of data collections per one inversion pulse, and to increase the number of applications of the inversion pulses (the number of times of LL (Looker-Locker) experiments) in one repetition period. On the contrary, when the T₁ value is "large", it is desired to increase the application interval of the inversion pulse, to increase the number of data collections per one inversion pulse, and to decrease the number of applications of the inversion pulses (the number of times of LL (Looker-Locker) experiments) in one repetition period.

Accordingly, when the heart rate is "low" and the T₁ value is "small", it is desired to decrease the application interval of the inversion pulse, to decrease the number of data collections per one inversion pulse, and to increase the number of applications of the inversion pulses (the number of times of LL (Looker-Locker) experiments) in one repetition period. On the contrary, when the heart rate is "high" and the T₁ value is "large", it is desired to increase the application interval of the inversion pulse, to increase the number of data collections per one inversion pulse, and to decrease the number of applications of the inversion pulses (the number of times of LL (Looker-Locker) experiments) in one repetition period.

Accordingly, in the case at Step S320d (the heart rate is "low" and the T₁ value is "small"), the processing circuitry 150 performs setting by the setting function 150c to decrease the application interval of the inversion pulse, to decrease the number of data collections per one inversion pulse, and to increase the number of applications of the inversion pulses in one repetition period.

In the case at Step S320a (the heart rate is "high" and the T₁ value is "large"), the processing circuitry 150 performs setting by the setting function 150c to increase the application interval of the inversion pulse, to increase the number of data collections per one inversion pulse, and to decrease the number of applications of the inversion pulses in one repetition period.

Regarding the cases at Step S320b and Step S320c, the processing circuitry 150 performs setting, for example, to be intermediate between Step S320d and Step S320a.

Next, the case at Step S320b (the heart rate is "high" and the T₁ value is "small") is described. In this case, because the T₁ value is small, there is no data point at which the TI in curve fitting is small, thereby causing an estimation error in the T₁ value. Therefore, in addition to the setting described above, the processing circuitry 150 sets the initial TI and performs setting so that data points having a small TI are collected sufficiently. The initial TI is illustrated in FIG. 2, for example. In the case of the "high" heart rate and the "small" T₁ value, the processing circuitry 150 sets the initial TI, for example, to 50 milliseconds, 150 milliseconds, and 200 milliseconds for each inversion pulse by the setting function 150c.

Here, the description returns to the case at Step S320d (the heart rate is "low" and the T₁ value is "small"). In this case, as in the case at Step S320b, there is no data point at which the TI is small, an estimation error occurs in the T₁ value. Therefore, the processing circuitry 150 performs setting of, for example, the initial TI. In addition, as described above, the processing circuitry 150 performs setting to decrease the application interval of the inversion pulse, for example, by decreasing the number of dummy cycles, and conversely to increase the number of applications of the inversion pulses in one repetition period. Typically, the processing circuitry 150 sets up the pattern of the pulse sequence to (3, (1), 3, (1), 3, (1), 2", and sets a set of the initial TIs, for example, to 50 milliseconds, 100 milliseconds, 300 milliseconds, and 500 milliseconds.

Further, when the T₁ value is large, as described in the second embodiment, longitudinal magnetization may not be sufficiently relaxed before the next inversion pulse is applied, and the data point at which the TI becomes the longest may not have a sufficiently large value. Therefore, in the case at Step S320a (the heart rate is "high" and the T₁ value is "large") and the case at Step S320c (the heart rate is "low" and the T₁ value is "large"), the processing circuitry 150 performs setting by the setting function 150c to increase the application interval of the inversion pulse, to increase the number of data collections per one inversion pulse, and to decrease the number of applications of the inversion pulses in one repetition period.

In the case at Step S320c, as compared to the case at Step S320a, the phenomenon that the longitudinal magnetization is not sufficiently relaxed does not easily occur. Therefore, in the case at Step S320c, as compared to the case at Step S320a, the processing circuitry 150 may not increase the application interval of the inversion pulse so much.

Subsequently, the processing circuitry 150 transmits the imaging conditions set at any of Steps S320a to S320d to the sequence control circuitry 10. The sequence control circuitry 10 having received the imaging conditions set by the processing circuitry 150 executes the pulse sequence by using the received imaging conditions (Step S330). The processing circuitry 150 acquires data related to the plurality of TIs based on the pulse sequence executed by the sequence control circuitry 10 at Step S330. The processing circuitry 150 generates the T₁ map by the generation function 150b by performing curve fitting and other processing with respect to the acquired data related to the TIs (Step S340). The processing circuitry 150 causes the display 135 to display the generated T₁ map by the control function 150a. The display 135 displays the generated T₁ map (Step S350) .

In this manner, in the third embodiment, the processing circuitry 150 sets the pattern of the pulse sequence based on both the values of the heart rate and the T₁ value of the imaging target. Accordingly, the magnetic resonance imaging apparatus according to the third embodiment can set more appropriate pulse sequence according to the subject P and an imaging object.

### Fourth embodiment

Embodiments are not limited to the above examples. In the first to third embodiments, there has been described a case where the processing circuitry 150 sets the number of heartbeats or pulsebeats between inversion pulses by the setting function 150c based on the information on the heartbeats or pulsebeats, to set the pattern defining a relation between the heartbeats or pulsebeats, the inversion pulse, and the data collection timing. The embodiment is not limited thereto.

For example, the processing circuitry 150 can set a pattern defining a relation between the heartbeats or pulsebeats, the inversion pulse, and the data collection timing by setting a time during which a data collection is continuously performed after an application of the inversion pulse by the setting function 150c based on the information on the heartbeats or pulsebeats.

In the embodiments described above, the sequence control circuitry 10 performs a data collection for a predetermined number of times at a predetermined timing based on the heartbeats of a subject, for example, as in the pattern "3, (3), 3, (3), 5". In a fourth embodiment, the sequence control circuitry 10 performs a data collection continuously for a predetermined time after an application of the inversion pulse. For example, if the time during which a data collection is continuously performed is three seconds after an application of the inversion pulse, the sequence control circuitry 10 continuously performs a data collection until three seconds has passed after an application of the inversion pulse, for each heartbeat. As an example, the sequence control circuitry 10 performs a data collection three times at a time point of 0.5 second, 1.5 seconds, and 2.5 seconds after an application of the inversion pulse. In this case, for example, if the heart rate of the subject increases, a data collection performed by the sequence control circuitry 10 is four times. Further, if the heart rate of the subject decreases, a data collection performed by the sequence control circuitry 10 is two times.

In this manner, when a time during which a data collection is continuously performed after an application of an inversion pulse is fixed, if the heart rate of the subject increases, the data collection interval becomes short, and thus the number of data collections increases. As a result, if the heart rate of the subject increases, the sequence control circuitry 10 may perform data collections for the number of times more than the required number of data collections, thereby increasing the total imaging time. On the contrary, if the heart rate of the subject decreases, the data collection interval becomes long, thereby decreasing the number of data collections. As a result, if the heart rate of the subject decreases, the number of data collections may not be sufficient.

Under such a background, in the fourth embodiment, the processing circuitry 150 sets a time during which a data collection is continuously performed after an application of an inversion pulse by the setting function 150c based on the information on the heartbeats or the pulsebeats. For example, if the heart rate or the pulse rate of a subject exceeds a predetermined threshold, the processing circuitry 150 sets the time during which a data collection is continuously performed after an application of the inversion pulse by the setting function 150c, so that the time during which a data collection is continuously performed after an application of the inversion pulse becomes shorter than a case where the heart rate or the pulse rate of the subject does not exceed the predetermined threshold. For example, if the heart rate of the subject is equal to or higher than the predetermined threshold, the processing circuitry 150 sets the time during which a data collection is continuously performed after an application of the inversion pulse to four seconds by the setting function 150c, and if the heart rate of the subject is lower than the predetermined threshold, the processing circuitry 150 sets the time during which a data collection is continuously performed after an application of the inversion pulse to five seconds by the setting function 150c. Further, for example, if the heart rate or the pulse rate of the subject falls below the predetermined threshold, the processing circuitry 150 sets, by the setting function 150c, the time during which a data collection is continuously performed after an application of the inversion pulse so that the time during which a data collection is continuously performed after an application of the inversion pulse becomes longer than a case where the heart rate or the pulse rate of the subject does not fall below the predetermined threshold.

Accordingly, in the magnetic resonance imaging apparatus 100 according to the fourth embodiment, the sequence control circuitry 10 can perform imaging with necessary and sufficient imaging time and the number of times of imaging, according to the heart rate (or the pulse rate) of the subject, without increasing the total imaging time and avoiding a case where the number of data collections is not sufficient.

### Fifth embodiment

In a fifth embodiment, there is described a case where the processing circuitry 150 collects information on heartbeats or pulsebeats by the control function 150a on a real time basis during execution of a pulse sequence to dynamically change a pattern defining a relation between the heartbeats or pulsebeats, the inversion pulse, and the data collection timing, based on the information collected during execution of the pulse sequence, and the sequence control circuitry 10 executes the pulse sequence based on the changed pattern.

As an example, the processing circuitry 150 dynamically sets the time during which a data collection is performed after an application of an inversion pulse, by the setting function 150c based on the information on the heartbeats or the pulsebeats. For example, if the heart rate or the pulse rate of a subject exceeds a predetermined threshold, the processing circuitry 150 sets the time during which a data collection is performed after an application of the inversion pulse by the setting function 150c, so that the time during which a data collection is performed after an application of the inversion pulse becomes shorter than a case where the heart rate or the pulse rate of the subject does not exceed the predetermined threshold. For example, if the heart rate of the subject is equal to or higher than the predetermined threshold, and when an inversion pulse is applied next, the processing circuitry 150 sets the time during which a data collection is performed after an application of the inversion pulse to four seconds by the setting function 150c, and if the heart rate of the subject is lower than the predetermined threshold, and when an inversion pulse is applied next, the processing circuitry 150 sets the time during which a data collection is performed after an application of the inversion pulse to five seconds by the setting function 150c.

In this manner, the processing circuitry 150 dynamically changes the data collection pattern by the setting function 150c according to the heart rate or the like of the subject. The sequence control circuitry 10 executes the pulse sequence based on the changed pattern. Accordingly, in the magnetic resonance imaging apparatus 100 according to the fifth embodiment, the sequence control circuitry 10 can execute a pulse sequence having been flexibly optimized due to the change of the heart rate or the like of the subject.

As another example, the processing circuitry 150 dynamically changes the pattern defining the relation between the heartbeats or pulsebeats, the inversion pulse, and the data collection timing by the setting function 150c by dynamically changing the heart rate or the like, for example, in a waiting time, based on the information on the heartbeats or the pulsebeats. For example, if a state in which the heart rate of the subject is equal to or higher than a predetermined threshold is maintained, the processing circuitry 150 sets the pattern of the pulse sequence to be executed to "3, (3), 3, (3), 5" by the setting function 150c. Further, if the heart rate of the subject has changed to be less than the predetermined threshold, it is decided that the waiting time for collection can be made short. Therefore, the processing circuitry 150 dynamically changes the pattern of the pulse sequence to be executed to "3, (2), 3, (3), 5" by the setting function 150c. The sequence control circuitry 10 performs an application of the inversion pulse and data collection at a timing according to the changed pattern of the pulse sequence. Accordingly, reduction of the imaging time can be realized by decreasing, for example, an unnecessary waiting time, and an imaging failure caused because the time from an application of an inversion pulse to data collection is too short can be prevented.

The processing circuitry 150 can dynamically change the pattern defining the relation between the heartbeats or pulsebeats, the inversion pulse, and the data collection timing, by the setting function 150c, for example, based on information on abnormal cardiac rhythm. As an example, upon detection of abnormal cardiac rhythm by the setting function 150c, the processing circuitry 150 decides that the data of that portion needs to be collected again, and transmits a signal indicating this matter to the sequence control circuitry 10. The sequence control circuitry 10 having received the notification of detection of abnormal cardiac rhythm extends the period for performing the data collection, for example, by one more heartbeat to perform the data collection.

As described above, according to the magnetic resonance imaging apparatus 100 of the fifth embodiment, a pulse sequence having been flexibly optimized with respect to a change of the heart rate or the pulse rate of the subject can be executed.

### Other embodiments

In the first to fifth embodiments, there has been described a case where the processing circuitry 150 generates the T₁ map by the generation function 150b. However, the embodiment is not limited thereto. The processing circuitry 150 can generate an ECV (Extracellular Volume fraction) map. The ECV map represents an extracellular volume of, for example, cardiac muscle, and a value thereof increases, for example, in the case of diffuse myocardial fibrosis. The ECV map of the cardiac muscle can be generated based on values of T₁ of the cardiac muscle before an input of a contrast agent, T₁ of the cardiac muscle after an input of the contrast agent, T₁ of the blood before an input of the contrast agent, and T₁ of the blood after an input of the contrast agent.

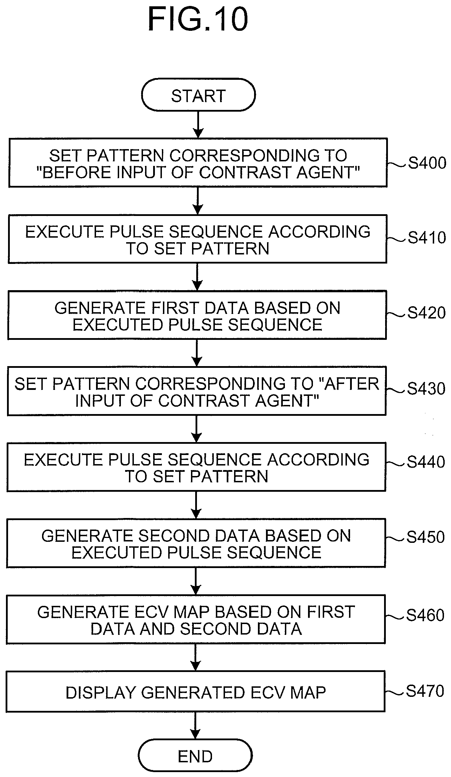

FIG. 10 illustrates a flow of processing. FIG. 10 is a flowchart for explaining a flow of the processing performed by the magnetic resonance imaging apparatus 100 according to another embodiment.

The processing circuitry 150 sets the pattern of the pulse sequence corresponding to "before input of contrast agent", for example, by performing the process at Step S202a described with reference to FIG. 6 by the setting function 150c (Step S400). Subsequently, the sequence control circuitry 10 having received the setting set by the processing circuitry 150 at Step S400 executes the pulse sequence according to the set pattern (Step S410). The processing circuitry 150 generates first data by the generation function 150b based on the pulse sequence executed at Step S410 (Step S420) . The first data is, for example, the T₁ value of the cardiac muscle before an input of a contrast agent and the T₁ value of the blood before an input of the contrast agent, or one of these. In other words, the processing circuitry 150 can acquire both the T₁ value of the cardiac muscle and the T₁ value of the blood by one imaging in the processes at Step S400 to Step S420, or can repeat imaging at Step S400 to Step S420 twice by changing the imaging conditions to acquire both the T₁ value of the cardiac muscle and the T₁ value of the blood by imaging performed twice in total.

Subsequently, the processing circuitry 150 sets the pattern of the pulse sequence corresponding to "after input of contrast agent", for example, by performing the process at Step S202b described with reference to FIG. 6 by the setting function 150c (Step S430). Subsequently, the sequence control circuitry 10 having received the setting set by the processing circuitry 150 at Step S430 executes the pulse sequence according to the set pattern (Step S440). The processing circuitry 150 generates second data by the generation function 150b based on the pulse sequence executed at Step S440 (Step S450) . The second data is, for example, the T₁ value of the cardiac muscle after an input of a contrast agent and the T₁ value of the blood after an input of the contrast agent, or one of these. In other words, the processing circuitry 150 can acquire both the T₁ value of the cardiac muscle and the T₁ value of the blood by one imaging in the processes at Step S430 to Step S450, or can repeat imaging at Step S430 to Step S450 twice by changing the imaging conditions to acquire both the T₁ value of the cardiac muscle and the T₁ value of the blood by imaging performed twice in total.

At Step S460, the processing circuitry 150 generates the ECV map by the generation function 150b based on the first data and the second data (Step S460). The processing circuitry 150 causes the display 135 to display the ECV map generated at Step S460 (Step S470).

In the present embodiment, a case where the ECV map is generated in the second embodiment has been described; however, the embodiment is not limited thereto. For example, the ECV map can be generated, for example, in the first and third embodiments. Further, a case where the input of information on the T₁ value is received manually in the second embodiment has been described; however, the embodiment is not limited thereto. The magnetic resonance imaging apparatus 100 can acquire the value of the T₁ value automatically, to set the appropriate pattern of the pulse sequence, for example, adaptively.

Embodiments are not limited to those described above. For example, the GUI described in the second embodiment, such as the GUI illustrated in FIG. 8, can be also applied to the first embodiment.

### Program

The instructions shown in the process procedures described in the above embodiments can be executed based on a program as software. As a general-purpose computer system stores the program therein in advance and reads the program, it is possible to obtain effects identical to those realized by the magnetic resonance imaging apparatus 100 and the image processing apparatus 200 described in the above embodiments. The instructions described in the above embodiments are stored, as a program that can be executed by a computer, in a recording medium such as a magnetic disk (such as a flexible disk or a hard disk), an optical disk (such as a CD-ROM, a CD-R, a CD-RW, a DVD-ROM, a DVD±R, a DVD±RW), a semiconductor memory, or other types of recording media in the same category. As far as the computer or an incorporating system thereof is a readable storage medium, its storage format can be of any type. As the computer reads the program from the storage medium and executes instructions described in the program based on the program on a CPU, it is possible to realize operations identical to those of the magnetic resonance imaging apparatus and the image processing apparatus described in the above embodiments. It is needles to mention that, when the computer acquires or reads the program, the acquisition or reading can be performed through a network.

Further, it is also possible that a part of the respective processes for realizing the above embodiments can be performed with, for example, an OS (Operating System) being operated on a computer based on instructions from a program installed from a storage medium into the computer or an incorporating system thereof, database management software, or MW (middleware) such as a network.

Furthermore, the type of the storage medium is not limited to a medium independent from a computer or an incorporating system thereof, and the type also includes a storage medium having downloaded and stored therein, or temporarily stored therein, a program transmitted through a LAN (Local Area Network), the Internet, and the like.

Further, the number of the storage medium is not limited to one, and when processes in the embodiments described above are performed by plural media, these media are also included in the storage medium in the above embodiments, and the configuration of such media can be of any type.

The computer or the incorporating system thereof in the above embodiments is used for performing the respective processes in the embodiments described above based on a program stored in a storage medium, and can have any type of configuration such as a device constituted by any one of a personal computer, a microcomputer, and the like, or a system in which a plurality of devices are connected to one another through a network.

Further, the computer in the above embodiment is not limited to a personal computer, and also includes devices such as an arithmetic processing unit and a microcomputer. The computer is a collective term for a device or an apparatus that can realize the functions in the above embodiments with a program.

### Hardware configuration

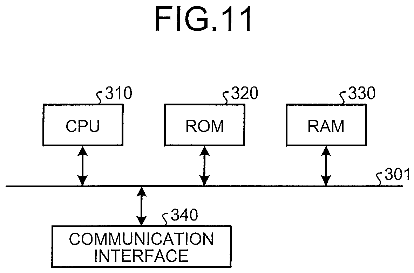

FIG. 11 is a diagram illustrating a hardware configuration of the image processing apparatus 200 according to the embodiments. The image processing apparatus 200 according to the embodiments described above includes a control device such as a CPU (Central Processing Unit) 310, storage units such as a ROM (Read Only Memory) 320, a RAM (Radom Access Memory) 330, and the like, a communication interface 340 that is connected to a network to perform communication, and a bus 301 that connects the respective elements to one another. The program to be executed by the image processing apparatus 200 according to the embodiments described above is, for example, incorporated in advance in the ROM 320 and distributed. Further, the program executed by the image processing apparatus 200 according to the embodiments described above can cause a computer to function as the respective elements of the image processing apparatus 200 described above. In the computer, the CPU 310 can read the program from a computer-readable storage medium on a main storage unit to execute the program.

According to the magnetic resonance imaging apparatus according to at least one of the embodiments described above, a data collection can be performed efficiently.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A magnetic resonance imaging apparatus (100) comprising:
processing circuitry (150) configured to set a pattern based on information on heartbeats or pulsebeats of a subject,
the pattern being an imaging condition of a pulse sequence for collecting data at a plurality of timings along a relaxation curve of longitudinal magnetization in synchronization with heartbeats or pulsebeats and the pattern
defining a relation between heartbeats or pulsebeats, an inversion pulse, and a data collection timing; and
sequence control circuitry (10) configured to control execution of the pulse sequence according to the pattern.

2. The magnetic resonance imaging apparatus (100) according to claim 1, wherein the processing circuitry (150) is configured to generate at least one of a T₁ map and an ECV map by using data collected by executing the pulse sequence.

3. The magnetic resonance imaging apparatus (100) according to claim 1, wherein when a heart rate or a pulse rate of the subject falls below a predetermined threshold, the processing circuitry (150) is configured to perform setting so that number of heartbeats or pulsebeats between inversion pulses becomes smaller as compared to a case where the heart rate or the pulse rate of the subject does not fall below the predetermined threshold.

4. The magnetic resonance imaging apparatus (100) according to claim 1, wherein when a heart rate or a pulse rate of the subject exceeds a predetermined threshold, the processing circuitry (150) is configured to perform setting so that number of heartbeats or pulsebeats between inversion pulses becomes larger as compared to a case where the heart rate or the pulse rate of the subject does not exceed the predetermined threshold.

5. The magnetic resonance imaging apparatus (100) according to claim 1, wherein
the pulse sequence is a pulse sequence of a MOLLI (modified Look-Locker Inversion Recovery) method, and
the processing circuitry (150) is configured to set the pattern by designating the plurality of timings.

6. The magnetic resonance imaging apparatus (100) according to claim 1, wherein the processing circuitry (150) is configured to set the pattern by designating number of applications of inversion pulses and number of data collections per one inversion pulse based on the information.

7. The magnetic resonance imaging apparatus (100) according to claim 1, wherein
the processing circuitry (150) is configured to:
cause a display to display candidates of the pattern based on the information,
receive an input of a change of the pattern from a user who has referred to the display (135), and
set the pattern based on the received input.

8. The magnetic resonance imaging apparatus (100) according to claim 1, wherein the processing circuitry (150) is configured to set the pattern based on information on heartbeats or pulsebeats of the subject and information on a T₁ value of an imaging target.

9. The magnetic resonance imaging apparatus (100) according to claim 1, wherein the processing circuitry (150) is configured to set the pattern by setting a time from an application of the inversion pulse to the data collection based on the information.

10. The magnetic resonance imaging apparatus (100) according to claim 1, wherein
the processing circuitry (150) is configured to dynamically change the pattern during execution of the pulse sequence based on information on heartbeats or pulsebeats collected during execution of the pulse sequence, and
the sequence control circuitry (10) is configured to execute the pulse sequence based on the changed pattern.

11. A magnetic resonance imaging apparatus (100) comprising:
processing circuitry (150) configured to set a pattern based on information on a T₁ value of an imaging target, the pattern being an imaging condition of a pulse sequence for collecting data at a plurality of timings along a relaxation curve of longitudinal magnetization in synchronization with heartbeats or pulsebeats and the pattern defining a relation between heartbeats or pulsebeats, an inversion pulse, and a data collection timing; and
sequence control circuitry (10) configured to control execution of a pulse sequence according to the pattern.

12. The magnetic resonance imaging apparatus (100) according to claim 11, wherein the processing circuitry (150) is configured to generate at least one of a T₁ map and an ECV map by using data collected by executing the pulse sequence.

13. The magnetic resonance imaging apparatus (100) according to claim 11, wherein when a T₁ value of the imaging target falls below a predetermined threshold, the processing circuitry (150) is configured to perform setting so that number of heartbeats or pulsebeats between inversion pulses becomes smaller as compared to a case where the T₁ value of the imaging target does not fall below the predetermined threshold.

14. The magnetic resonance imaging apparatus (100) according to claim 11, wherein when a T₁ value of the imaging target exceeds a predetermined threshold, the processing circuitry (150) is configured to perform setting so that number of heartbeats or pulsebeats between inversion pulses becomes larger as compared to a case where the T₁ value of the imaging target does not exceed the predetermined threshold.

15. The magnetic resonance imaging apparatus (100) according to claim 11, wherein the processing circuitry (150) is configured to set the pattern by designating number of applications of inversion pulses and number of data collections per one inversion pulse based on the information.

16. The magnetic resonance imaging apparatus (100) according to 11, wherein the processing circuitry (150) is configured to:
receive an input of the information from a user, and
set the imaging condition based on the received input.

17. The magnetic resonance imaging apparatus (100) according to claim 11, wherein
the processing circuitry (150) is configured to:
cause a display (135) to display candidates of the pattern based on the information,
receive an input of a change of the pattern from a user who has referred to the display (135), and
set the pattern based on the input.

18. The magnetic resonance imaging apparatus (100) according to claim 11, wherein the information includes at least one of information on presence or absence of a contrast agent, information on a body part to be imaged, and a T₁ value input from a user.

19. A magnetic resonance imaging method to be performed by a magnetic resonance imaging apparatus (100), the magnetic resonance imaging method comprising:
setting, by processing circuitry (150), a pattern based on information on heartbeats or pulsebeats of a subject, the pattern being an imaging condition of a pulse sequence for collecting data at a plurality of timings along a relaxation curve of longitudinal magnetization in synchronization with heartbeats or pulsebeats, the pattern defining a relation between heartbeats or pulsebeats, an inversion pulse, and a data collection timing; and
controlling execution of a pulse sequence according to the pattern by sequence control circuitry.

20. A magnetic resonance imaging method to be performed by a magnetic resonance imaging apparatus (100), the magnetic resonance imaging method comprising:
setting, by processing circuitry, a pattern based on information on a T₁ value of an imaging target, the pattern being an imaging condition of a pulse sequence for collecting data at a plurality of timings along a relaxation curve of longitudinal magnetization in synchronization with heartbeats or pulsebeats, the pattern defining a relation between heartbeats or pulsebeats, an inversion pulse, and a data collection timing; and
controlling, by sequence control circuitry (10), execution of the pulse sequence according to the pattern.
